# EUROPÄISCHE PATENTSCHRIFT

(11) **EP 4 475 439 B1**
(45) Veröffentlichungstag und Bekanntmachung des Hinweises auf die Patenterteilung: **19.03.2025**
(21) Anmeldenummer: 23211934.7
(22) Anmeldetag: 24.11.2023
(51) Int. Cl.: H03K 17/968

(54) **ANORDNUNG EINES SCHALTGERÄTES MIT EINEM FUNKTIONSMODUL, FUNKTIONSMODUL UND VERFAHREN ZUM BETRIEB EINES SOLCHEN**
ARRANGEMENT OF A SWITCHING DEVICE WITH A FUNCTIONAL MODULE, FUNCTIONAL MODULE AND METHOD FOR OPERATING SUCH A DEVICE
AGENCEMENT D'UN APPAREIL DE COMMUTATION DOTÉ D'UN MODULE FONCTIONNEL, MODULE FONCTIONNEL ET PROCÉDÉ DE FONCTIONNEMENT D'UN TEL MODULE FONCTIONNEL

(30) Priorität: 07.06.2023 DE 102023114972
(43) Veröffentlichungstag der Anmeldung: 11.12.2024
(73) Patentinhaber: Insta GmbH, 58509 Lüdenscheid (DE)
(72) Erfinder:
(74) Vertreter: Fobbe, Tobias

(56) Entgegenhaltungen:
- WO-A1-2016/177382
- AT-B1- 525 242
- DE-A1- 102017 127 368

## Beschreibung

Die Erfindung betrifft eine Anordnung eines Funktionsmoduls nach Anspruch 1 zum Einbau in eine Installationsdose mit einem manuell zu betätigenden elektrischen/elektronischen Schaltgerät der Gebäudeinstallationstechnik, welches Funktionsmodul durch die Betätigung eines an dem elektrischen/elektronischen Schaltgerät angeschlossenen Betätigungselementes eines Oberteils des elektrischen/elektronischen Schaltgerätes beeinflussbar ist, wobei das Funktionsmodul zumindest eine Schnittstelle aufweist, mittels welcher zumindest ein Aktor entsprechend einer Betätigung des Betätigungselements ansteuerbar ist. Die Erfindung betrifft ferner ein Verfahren zum Betrieb einer solchen Anordnung nach Anspruch 12.

Funktionsmodule für elektrische/elektronische Schaltgeräte der Gebäudeinstallationstechnik (etwa *www.jung-group.com*/*de-DE*/*Wippschalter-Universal-Aus-Wechsel-10-AX-250-V*/*506-U*) , wobei auf das in einem Installationshohlraum befindliche elektrische/elektronische Schaltgerät ein Oberteil aufsetzbar ist, sind in der Regel dafür vorgesehen, über ihre unabhängigen Kanäle Aktoren und/oder Sensoren anzusteuern und zwar sowohl über einen Schalter oder Taster als auch über ein externes Gerät, beispielsweise ein mobiles Endgerät, via Funksignal. Derartige Funktionsmodule werden oftmals als Tasterschnittstelle, Dimmaktor, Schaltaktor oder Jalousieaktor eingesetzt und verfügen beispielsweise über zwei bis vier unabhängige Kanäle. Insofern sind die Funktionsmodule zur Erweiterung der Funktion elektrischer/elektronischer Schaltgeräte, beispielsweise eines Tasters oder Schalters, vorgesehen. Insofern handelt es sich bei einem Funktionsmodul um ein von dem elektrischen/elektronischen Schaltgerät zu unterscheidendes Bauteil. Dabei geht das Funktionsmodul eine Symbiose mit dem elektrischen/elektronischen Schaltgerät ein, indem es dem elektrischen/elektronischen Schaltgerät zusätzliche Funktionen zuweist und optional auch eine Fernbetätigung des elektrischen/elektronischen Schaltgerätes ermöglicht, beispielsweise das Dimmen von Leuchten durch Betätigung des elektrischen/elektronischen Schaltgerätes oder über eine Betätigung einer Applikation auf einem mobilen Endgerät.

Ein dem Oberbegriff des Hauptanspruches entsprechendes Funktionsmodul beziehungsweise eine entsprechende Anordnung ist somit aus dem Stand der Technik beispielsweise gemäß der Website *nexentro.de* bekannt. Ein solches Funktionsmodul ist für die Gebäudeinstallationstechnik ausgelegt und weist ein aus einem Sockelteil und einem Deckelteil bestehendes Gehäuse auf, in dessen Innenraum auf zumindest einer elektrischen Leiterplatte die zur Funktion notwendigen elektrischen/elektronischen Bauteile untergebracht sind. Die elektrische Leiterplatte steht mit mehreren Anschlusskabeln zur Bildung einer Schnittstelle in Verbindung, über welche der Anschluss eines elektrischen/elektronischen Schaltgerätes erfolgt. Über mehrere unabhängige Kanäle können Telegramme ausgesendet werden, wobei die Telegramme zur Ansteuerung verschiedener Aktoren, beispielsweise Leuchten, Jalousien oder Steckdosen, oder Sensoren, beispielsweise Tastsensoren, Verwendung finden. Durch die Installation der Funktionsmodule in Installationsdosen werden die herkömmlichen, elektromechanischen Schalter "smart" gemacht.

Um das Tastsignal eines elektromechanischen Schalters an einem vorbekannten Funktionsmodul auswerten zu können, müssen mindestens drei Leitungen angeschlossen werden (Außenleiter beziehungsweise Phase L und geschalteter Ausgang/Steuerleitung und eine Steuerleitung zum Anschluss des Schalters). Bei Zweifach- und Jalousieanwendungen kommt eine weitere Steuerleitung hinzu; bei Schalt- oder Dimm-Anwendungen eine oder zwei Steuerleitungen.

Da durch den begrenzten Platzbedarf eine Unterbringung eines Funktionsmoduls und des Kabelgutes in der Unterputzdose herausfordernd ist, stellt das Weglassen jeder Leitung eine erhebliche Optimierung dar, insbesondere, weil der Platzbedarf in dem Installationshohlraum und der Installationsaufwand signifikant abgesenkt werden können. Zudem wird durch die reduzierte Anzahl von zu verwendenden elektrischen Leitungen der Aufbau verständlicher und kann so durch die installierende Person sicherer und nachvollziehbarer durchgeführt werden. Mithin ergeben sich weniger Fehlerquellen. Aus diesen Gründen ergeben sich Hinderungsgründe für die breite Masse der Anwender, die kein Fachinstallateur sind, ein vorstehend beschriebenes Funktionsmodul einzusetzen.

Zudem erfordert die optimale Steuerung beispielsweise von Jalousien, Steckdosen und dimmbaren Leuchtmitteln mittels eines solchen Funktionsmoduls jedenfalls Taster, also einen nicht permanent geschlossenen Schalter. Damit wird unter Umständen eine aufwendige Umrüstung der bestehenden Gebäudesysteminfrastruktur von Schalter in Taster erforderlich - auch dieses schreckt viele potentielle Anwender von der Implementierung solcher Funktionsmodule zum "smart machen" von Dimmern, Jalousien und dergleichen ab.

AT 512 033 B1, US 2017/0062168 A1, DE 10 2005 063 070 A1 und EP 1 014 001 A2 offenbaren die Möglichkeit der Übertragung von Betätigungssignalen über Magnetfelder für Schaltgeräte. Die hier offenbarten Schaltgeräte sind bereits werksseitig vollständig montiert und werden, sofern überhaupt möglich, nur insgesamt ausgetauscht. Dies birgt den Nachteil erhöhter Kosten beim Umbau. Darüber hinaus geht die Übertragung von Betätigungssignalen über Magnetfelder mit dem Nachteil einher, dass kostspielige und im Kontext der Gebäudeinstallationstechnik große (und damit bauraumbeanspruchende) und/oder schwere (die Schalthaptik beeinflussende) Magnete verbaut werden müssen. Zudem haben Magnete den Nachteil, dass sie grundsätzlich entmagnetisierbar sind, beispielsweise durch andere Magnete, Erschütterungen oder hohe Temperaturen.

WO 2016/177382 A1 beschreibt eine Bedienvorrichtung für ein elektronisches Haushaltsgerät, die eine Abdeckplatte mit einem zumindest teilweise elastisch verformbaren und/oder bewegbaren Bedienabschnitt und einen optischen Sensor zum Erfassen einer Druckbetätigung im Bereich des Bedienabschnitts umfasst. Der optische Sensor weist ein Diodenelement auf, das beabstandet zu einer der Benutzerseite abgewandten Seite der Abdeckplatte angeordnet ist und abwechselnd als Strahlungsemissionselement und als Strahlungsempfangselement betreibbar ist. Außerdem ist eine Puffereinrichtung vorgesehen, die die Energie der emittierten Strahlung zwischenspeichert und die zwischengespeicherte Strahlungsenergie während des Betriebs des Diodenelements als Strahlungsempfangselement als elektromagnetische Strahlung wieder abgibt.

DE 10 2017 127 368 A1 beschreibt eine Bedienvorrichtung mit einem Grundelement und einer Sende-Empfangseinrichtung, die fest an dem Grundelement angeordnet ist, einem Bedienelement, das gegenüber dem Grundelement zwischen einer ersten Extremstellungen einer zweiten Extremstellung bewegbar ist und einem Optikelement, das fest an dem Bedienelement angeordnet ist, zum Umlenken des Lichts der Sende-Empfangseinrichtung. Das Sendeteil der Sende-Empfangseinrichtung sendet Licht aus, welches von dem Bedienelement in Richtung auf das Empfangsteil umgelenkt und fokussiert wird. Dazu besitzt das Bedienelement ein Optikelement, welches als konkaver Reflektor ausgebildet ist.

AT 525 242 B1 beschreibt ein Funktionsmodul zum Einbau in eine Installationsdose für ein Schaltgerät der Gebäudeinstallationstechnik. Das Funktionsmodul ist beeinflussbar mittels eines Betätigungselementes eines Oberteils des Schaltgeräts, wobei an dem Oberteil des Schaltgeräts ein Magnet angeordnet ist, welcher bei Betätigung des Betätigungselements seine Position ändert. Das Funktionsmodul weist einen Sensor zur Erfassung des Magnetfeldes auf, so dass die Änderung des Magnetfeldes bei Betätigung des Betätigungselementes detektiert wird.

Ausgehend von diesem diskutierten Stand der Technik liegt der Erfindung die Aufgabe zugrunde, eine Anordnung eines Funktionsmoduls zum Einbau in eine Installationsdose mit einem manuell zu betätigenden elektrischen/elektronischen Schaltgerät der Gebäudeinstallationstechnik zu schaffen, mit dem der Verdrahtungsaufwand und damit die Installationskosten während des Einbaus reduziert, der in der Installationsdose verfügbare Raum erhöht und gleichzeitig der Betrieb eines Aktors ohne Ansteuerung durch einen Taster - sondern als Schalter - möglich ist, so dass eine besonders einfache und kostengünstige Nachrüstbarkeit der Funktionsmodule erreicht wird, wobei auf den Einsatz eines Magnets verzichtet werden kann.

Gelöst wird diese Aufgabe durch eine eingangs genannte, gattungsgemäße Anordnung mit den Merkmalen des Anspruchs 1. Vorteilhafte Ausgestaltungen ergeben sich aus den abhängigen Ansprüchen und der Beschreibung.

Ein Kerngedanke der Erfindung besteht darin, dass das erfindungsgemäße Funktionsmodul der erfindungsgemäßen Anordnung den bis dato erforderlichen kabelbasierten Anschluss an das elektrische/elektronische Schaltgerät, insbesondere ein als Schalter oder Taster ausgebildetes Schaltgerät, entbehrlich macht:
Dieses wird vorteilhafterweise erreicht, indem eine Detektion der Stellung des an dem elektrischen/elektronischen Schaltgerät fest gelagerten Betätigungselementes des Schaltgerätes durch das erfindungsgemäße Funktionsmodul vorgenommen und entsprechend ausgewertet wird.

Das zum Einbau in einen Installationshohlraum, etwa eine Installationsdose, geeignete, erfindungsgemäße Funktionsmodul für ein elektrisches/elektronisches Schaltgerät der Gebäudeinstallationstechnik ist mittels des Betätigungselementes des Oberteils des Schaltgerätes beeinflussbar, indem an dem Schaltgerät mindestens ein reflektierendes Element angeordnet ist. Ein solches reflektierendes Element kann beispielsweise ein Spiegel sein, der an der für den Anwender nicht erkennbaren Rückseite des Oberteils angeordnet ist. Damit ändert das reflektierende Element bei Betätigung des Schaltgerätes in Folge der Bewegung des Oberteils seine Position. Diese Positionsänderung wird durch einen Sensor zur Erfassung des optischen Signals, das durch einen Sender erzeugt wurde, bei Betätigung des Betätigungselementes detektiert. Es versteht sich vor diesem Hintergrund, dass das elektrische/elektronische Schaltgerät nicht zwingenderweise selbst eine elektrische/elektronische Schaltmimik aufweisen muss; es genügt das Bereitstellen eines durch einen Nutzer in verschiedene Positionen bringbaren Betätigungselements.

Bevorzugt ist vorgesehen, dass das reflektierende Element an der von dem Benutzer im Betrieb abgewandten Seite des Betätigungselementes angeordnet (mithin unsichtbar ist), insbesondere geklebt oder mechanisch an ihm fixiert, ist.

Gleichzeitig ist vorgesehen, dass das Funktionsmodul eine Auswerteeinheit aufweist, die dazu ausgelegt ist, zu erkennen, um welche Schaltgeräteart es sich bei dem Schaltgerät, durch welches das Funktionsmodul optisch angesteuert wird, handelt. Es gibt verschiedene Schaltgerätearten, die sich bezüglich ihrer nutzerseitigen Betätigungsbewegung unterscheiden. So springt etwa ein Schalter im Gegensatz zu einem Taster nicht selbsttätig in seine Ursprungsstellung zurück. Ein Drehknauf, der durch eine Drehung eine stufenlose Einstellung ermöglicht, stellt wiederum eine andere Schaltgeräteart dar. Diese Information, um welche Schaltgeräteart es sich handelt, fließt in die Art und Weise, wie der Aktor aufgrund einer bestimmten erkannten Veränderung des optischen Signals angesteuert wird, ein.

Das Funktionsmodul kann insbesondere als Nachrüstsatz vorgesehen sein. Das Schaltgerät ist dann üblicherweise ein elektrisches/elektronisches Schaltgerät. Die in dem Schaltgerät vorhandene elektrische/elektronische Aktorik wird nicht mehr benötigt; die Funktionalität wird durch das Funktionsmodul ersetzt. Ein vollständiges Austauschen des elektrisches/elektronisches Schaltgerätes ist jedoch nicht notwendig.

Geschickt wird sich durch die Erfindung die vorhandenen Schnittstellen zunutze gemacht, und zwar einerseits die Schnittstelle zwischen dem in einem Installationsraum fest installierten Schaltgerätbasisteil und einem Oberteil, was einen unkomplizierten Austausch des Betätigungselementes durch etwa mit zumindest einem reflektierenden Element ausgestatteten Betätigungselement ermöglicht und andererseits die elektrische Schnittstelle zwischen Aktor und Schaltgerät. So ist ein besonders einfacher Umbau möglich. So kann auch vorgesehen sein, dass im Rahmen des Nachrüstens das nicht-reflektierende Element an dem Betätigungselement angeschlossen wird.

Als Nachrüstsatz weist das Funktionsmodul üblicherweise ein Gehäuse auf, in dessen Innenraum auf zumindest einer elektrischen Leiterplatte zur Funktion notwendige elektrische/elektronische Bauteile untergebracht sind. Dabei weist die zumindest eine elektrische Leiterplatte zum Anschluss mehrerer elektrischer Leitungen zumindest eine Schnittstelle auf. So sind üblicherweise alle für den Betrieb erforderlichen Komponenten kompakt in einem typischerweise abgeschlossenen Gehäuse angeordnet, nach außen aufweisend die zum Betrieb erforderlichen Schnittstellen, insbesondere zum Ansteuern des Aktors und ggf. zur eigenen Stromversorgung. Die Stromversorgung kann auch durch eine Batterie oder durch die dem Aktor zur Verfügung gestellte, respektive geschaltete Energie oder einer Kombination daraus bereitgestellt werden. Durch die dadurch gewonnene Autarkie ist eine einfache Montage gewährleistet. Hierzu wird üblicherweise das elektrische/elektronische Schaltgerät ausgebaut, das Funktionsmodul in den freigelegten Installationshohlraum eingelegt, das reflektierende Element an dem Oberteil fixiert, die Kabel von dem Schaltmodul abgeklemmt und stattdessen teilweise an das Funktionsmodul angeschlossen, anschließend das Schaltmodul wieder in den Installationshohlraum eingesetzt und abschließend das Oberteil auf das elektrische/elektronische Schaltgerät aufgesteckt.

Zum funktionsmodulseitigen Erkennen, um welche Art von Schaltgerät es sich bei dem installierten, elektrischen/elektronischen Schaltgerät handelt, wird bevorzugt eine vorgegebene Betätigung des Schaltgerätes während einer Einrichteroutine durch einen Nutzer durchgeführt. Anhand der durch den Sensor zeitaufgelösten Erkennung des durch einen Sender erzeugten optischen Signals können Muster erkannt werden, die auf eine bestimmte Schaltgeräteart rückschließen lassen. So verbleibt bei einer einmaligen Betätigung ein Schalter in seiner Stellung, während ein Taster in seine Ursprungsstellung selbstständig zurückkehrt. Wieder anders verhält sich ein Drehknopf. Die dazugehörigen Muster der Veränderung des optischen Signals werden mit in dem Funktionsmodul hinterlegten oder über eine externe Datenverbindung zur Verfügung gestellten Mustern verglichen, sodass auf die Schaltgeräteart auf diese Weise vollautomatisch geschlossen werden kann. Auch ist auf diese Weise eine Kalibrierung des Sensors möglich, insbesondere in Bezug auf ein Oberteil, welches mehrkanalig genutzt wird (etwa ein Doppelschalter oder -taster).

Bevorzugt ist vorgesehen, dass für jede Aktorart (etwa Leuchten, Steckdosen oder Jalousien) je ein Funktionsmodul vorgesehen ist. Somit ist für ein bestimmtes Funktionsmodul der zu schaltende Aktor bekannt, sodass das Funktionsmodul bezüglich einer Ansteuerung hierauf abgestimmt sein kann. Hierdurch wird der benötigte Speicherplatz innerhalb des Funktionsmoduls reduziert.

Ferner kann vorgesehen sein, dass in dem Funktionsmodul für eine bestimmte Aktorart eine bestimmte aktorartspezifische Funktion implementiert ist, die auf Basis einer Standardbetätigung ausgelegt ist. Beim Auslösen der Funktion wird dann durch das Funktionsmodul die tatsächliche schaltgeräteseitige Betätigungsart in die funktionsseitige Standardbetätigung softwareseitig umgewandelt, wenn diese von der Standardbetätigung abweicht. Als Beispiel: Angenommen, die Funktion ist für einen Taster konzipiert, die Standardbetätigung ist somit diejenige eines Tasters. Wird durch das Funktionsmodul erkannt, dass es sich bei dem elektrischen/elektronischen Schaltgerät tatsächlich um einen Schalter handelt (die tatsächliche Betätigung ist diejenige eines Schalters), wandelt es die Schaltbetätigung intern als Tastersignal um und sendet diese an die aktorartspezifische Funktion zum Ansteuern des Aktors. Auf diese Weise muss nur für eine einzige Betätigungsart die entsprechende Funktion in dem, üblicherweise kompakt ausgeführten Funktionsmodul gespeichert werden, während trotzdem eine Ansteuerung mittels verschiedener Schaltgerätearten möglich ist. Hierdurch wird Speicherplatz gespart. Auch das Updaten der Funktion wird vereinfacht, da weniger Daten übertragen werden müssen.

Besonders bevorzugt weist das Funktionsmodul der erfindungsgemäßen Anordnung einen Dimmaktor zum Dimmen von dimmbaren Lasten, etwa Leuchtmitteln auf. Auf diese Art und Weise kann nicht nur die Funktionalität des Dimmens dimmbarer Lasten realisiert werden, sondern wird dadurch auch ermöglicht, das Dimmen ohne einen Taster (oder mittels eines Drehknopfs) zu verwenden. Damit wird der infrastrukturelle Aufwand erheblich abgesenkt, so dass der Anwender eher dazu angeregt wird, ein erfindungsgemäßes Funktionsmodul zu installieren.

Gemäß einer besonders bevorzugten Weiterbildung dieses, einen Dimmaktor aufweisenden erfindungsgemäßen Funktionsmoduls weist die Schnittstelle maximal einen Anschluss für den Neutralleiter, einen Anschluss für die Phase und einen Anschluss für die zu dimmende Last auf. Eine Verdrahtung des Funktionsmoduls mit dem elektromechanischen Schaltgerät entfällt. Mithin werden lediglich drei statt fünf Kabel (bei einem Zwei-Wege-Dimmer mit einer Taste sogar sechs Kabel) beziehungsweise im Zweidrahtbetrieb zwei statt vier Kabel (bei einem Zwei-Wege-Dimmer mit einer Taste sogar fünf Kabel) benötigt. Hierdurch kann vorteilhafterweise nicht nur der Installationsaufwand abgesenkt, sondern auch ein erheblicher Bauraum in der Installationsdose eingespart werden.

In einer alternativen Weiterbildung des Funktionsmoduls der erfindungsgemäßen Anordnung weist das Funktionsmodul einen Schaltaktor, insbesondere zum Schalten von Steckdosen, auf. Die Steckdose ist üblicherweise eine haushaltsübliche Steckdose zur Versorgung von elektrischen/elektronischen Geräten mit einer Spannung von etwa 110-230V, kann aber auch proprietäre Systeme mit einer Niederspannung umfassen. Da die Stellung des Schaltgerätes optisch über den Sensor erfasst wird, entfällt eine aufwendige Verdrahtung des Funktionsmoduls mit dem elektromechanischen Schaltgerät.

Gemäß einer besonders bevorzugten Weiterbildung dieses, einen Schaltaktor aufweisenden Funktionsmoduls der erfindungsgemäßen Anordnung weist die Schnittstelle maximal einen Anschluss für den Neutralleiter, einen Anschluss für die Phase und einen Anschluss für die zu schaltende Last auf. Mithin werden lediglich drei statt fünf Kabel benötigt. Hierdurch kann vorteilhafterweise nicht nur der Installationsaufwand abgesenkt, sondern auch ein erheblicher Bauraum in der Installationsdose eingespart werden.

In einer alternativen Weiterbildung des Funktionsmoduls der erfindungsgemäßen Anordnung weist das Funktionsmodul einen Jalousieaktor zum Steuern von Jalousien auf. Da die Stellung des Schaltgerätes optisch erfasst wird, entfällt eine Verdrahtung des Funktionsmoduls mit dem elektromechanischen Schaltgerät.

Gemäß einer besonders bevorzugten Weiterbildung dieses, einen Jalousieaktor aufweisenden Funktionsmoduls der erfindungsgemäßen Anordnung weist die Schnittstelle maximal einen Anschluss für den Neutralleiter, einen Anschluss für die Phase und zwei Anschlüsse für die zu steuernde Last auf. Mithin werden lediglich vier statt sieben Kabel benötigt. Hierdurch kann vorteilhafterweise nicht nur der Installationsaufwand abgesenkt, sondern auch ein erheblicher Bauraum in der Installationsdose eingespart werden.

In einer alternativen Weiterbildung des Funktionsmoduls der erfindungsgemäßen Anordnung weist das Funktionsmodul einen Tastsensor zum Betätigen eines elektrischen Gerätes auf. Da die Stellung des Schaltgeräts optisch über den Sensor erfasst wird, entfällt vorteilhafterweise eine Verdrahtung des Funktionsmoduls mit dem elektromechanischen Schaltgerät.

Gemäß einer besonders bevorzugten Weiterbildung dieses, einen Tastsensor aufweisenden erfindungsgemäßen Funktionsmoduls der erfindungsgemäßen Anordnung weist die Schnittstelle maximal einen Anschluss für den Neutralleiter und einen Anschluss für die Phase auf. Mithin werden lediglich zwei statt fünf Kabel benötigt (Anmerkung: Es ist entweder ein Anschluss über den Neutralleiter oder über eine Steuerleitung erforderlich). Hierdurch kann vorteilhafterweise nicht nur der Installationsaufwand abgesenkt, sondern auch ein erheblicher Bauraum in der Installationsdose eingespart werden.

In einer besonders bevorzugten Weiterbildung des Funktionsmoduls der erfindungsgemäßen Anordnung weist das Funktionsmodul einen Energiespeicher, insbesondere eine Batterie oder ein Akku, zur Energieversorgung auf. Hierdurch wird vorteilhafterweise erreicht, dass der Verdrahtungsaufwand noch weiter reduziert wird, da ein Anschluss an den Neutralleiter und ein Anschluss an die Phase ebenfalls entfallen kann.

In einer bevorzugten Weiterbildung des Funktionsmoduls der erfindungsgemäßen Anordnung ist der Sensor eine Photodiode, die bevorzugt außerhalb des spektralen Bereiches von 380 nm bis 780 nm emittiert, damit das optische Signal nicht zu erkennen ist, falls es zwischen dem Designrahmen und dem Oberteil hindurchscheint. Besonders bevorzugt weist der Sensor einen Tageslicht-Sperrfilter auf, so dass das Signal-zu-Rausch-Verhältnis weiter verbessert wird.

In einer alternativen Weiterbildung des Funktionsmoduls der erfindungsgemäßen Anordnung ist der Sender ein Laser. Dieser zeichnet sich durch eine hohe Intensität aus, so dass ein gutes Signal-zu-Rausch-Verhältnis erreicht wird.

In einer alternativen, besonderen kostengünstigen Weiterbildung des Funktionsmoduls der erfindungsgemäßen Anordnung ist der Sender eine LED.

Üblicherweise ist das Funktionsmodul rückwärtig zu dem elektrischen/elektronischen Schaltgerät innerhalb des für das elektrische/elektronische Schaltgerät vorgesehenen Installationshohlraumes, etwa einer Hohlwand- oder Unterputzdose, angeordnet. Für eine eindeutige Ausrichtung bei der Montage ist das Funktionsmodul bezüglich seiner Grundfläche an einen üblichen Installationshohlraum in seinen Außendimensionen angepasst, üblicherweise zumindest über ein Segment, etwa mehr als 180° kreisrund.

Ferner betrifft die Erfindung ein Verfahren zum Betrieb der erfindungsgemäßen Anordnung, umfassend die Schritte:
- Erzeugen des optischen Signals durch den Sender,
- Erfassen des optischen Signals durch den Sensor,
- Erfassen der Änderung des optischen Signals in Folge einer vorbestimmten Betätigung des Betätigungselementes in Folge der Bewegung des reflektierenden Elements,
- Auswerten der erfassten Änderung des optischen Signals durch eine Auswerteeinheit, dahingehend, um welche Schaltgeräteart es sich bei dem elektrischen/elektronischen Schaltgerät handelt, insbesondere, ob es sich um einen Schalter oder Taster handelt, und
- Ansteuerung eines Aktors durch das Funktionsmodul entsprechend einer vorgegebenen Funktionsweise in Abhängigkeit der Schaltgeräteart.

Nachfolgend ist die Erfindung unter Bezugnahme auf die beigefügten Figuren anhand diverser Ausführungsbeispiele beschrieben. Es zeigen:
- **Fig. 1:**: Eine schematische Querschnittsdarstellung der erfindungsgemäßen Anordnung, wobei das Funktionsmodul mit der Rückseite des Schaltgerätes gefügt ist, und
- **Fig. 2:**: eine schematische Darstellung des einen Schaltaktor aufweisenden Funktionsmoduls (rechts) aus der erfindungsgemäßen Anordnung im Vergleich zu einem vorbekannten Funktionsmodul (links), jeweils inklusive angedeuteter Verdrahtung bezüglich des Schaltgeräts.

In den verschiedenen Figuren sind gleiche Teile stets mit den gleichen Bezugszeichen versehen und werden daher in der Regel auch jeweils nur einmal benannt beziehungsweise erwähnt.

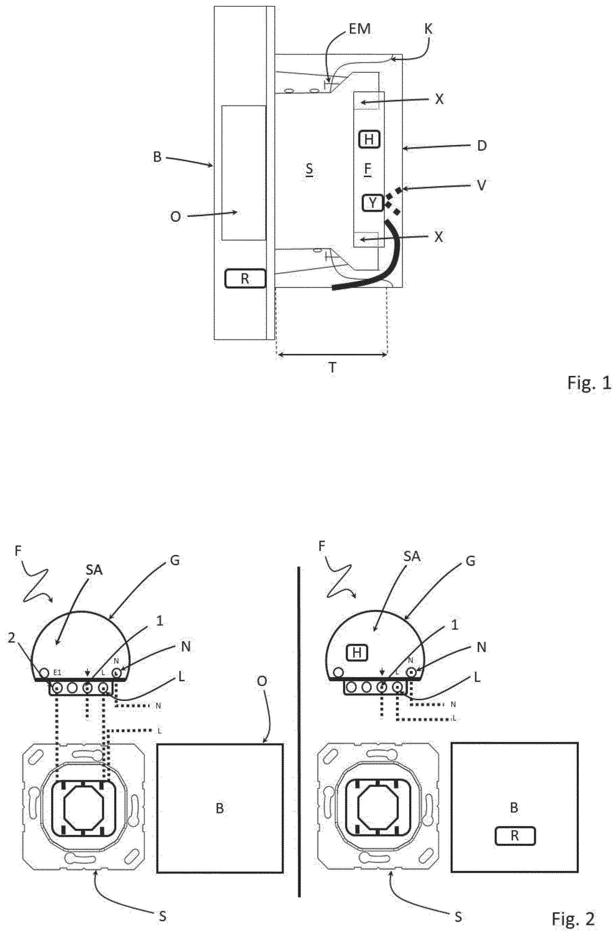

Figur 1 zeigt eine schematische Querschnittsdarstellung der erfindungsgemäßen Anordnung, die in einer Installationsdose D, insbesondere einer Unterputz- oder Hohlraumdose, angeordnet ist. Dabei verfügt das elektrische/elektronische Schaltgerät S über Spreizkrallen K, die mittels Einstellmittel EM verstellbar sind und zum Festlegen des elektrischen/elektronischen Schaltgerätes S in der Installationsdose D sorgen. Aufgrund von Ausnehmungen des Funktionsmoduls F kann dieses komplementär mit der Rückseite des elektrischen/elektronischen Schaltgerätes S in Eingriff gebracht werden, so dass wertvolle Einbautiefe T eingespart wird. Durch eine Betätigung eines an dem elektrischen/elektronischen Schaltgerät S angeschlossenen Betätigungselementes B eines Oberteils O des elektrischen/elektronischen Schaltgerätes S ist das elektrische/elektronische Schaltgerät S beeinflussbar, beispielsweise zum Schalten einer Lampe, indem der Sensor H die durch die Betätigung bedingte Änderung des durch den Sender Y emittierten optischen Signals V erfasst. Im Rahmen der Erfindung ist der Sender Y direkt auf eine Rückseite der Installationsdose D gerichtet. Von der Rückseite aus wird das optische Signal V in sämtliche Richtungen reflektiert, wobei ein Teil auf das reflektierende Element R gelangt, so dass die Positionsänderung des reflektierenden Elementes R sich in eine Intensitätsänderung am Sensor H übersetzt. Dabei weist das Funktionsmodul F eine Auswerteeinheit zur Auswertung der Änderung des optischen Signals V auf, die dazu eingerichtet ist, in Abhängigkeit der sensierten Änderung des optischen Signals V zu identifizieren, um welche Schaltgeräteart es sich bei dem elektrischen/elektronischen Schaltgerät S handelt, welche Identifikation in die funktionsmodulseitige Ansteuerung des Aktors einfließt. Ein elektrisches/elektronisches Schaltgerät S kann beispielsweise ein Schalter, ein Taster oder eine einfache, rein mechanische Wippenaufnahme darstellen. Vorteilhaft bei einem derartigen Funktionsmodul F ist, dass es zum einen keine Verkabelung des Funktionsmoduls F mit dem elektrischen/elektronischen Schaltgerät S erfordert und zum anderen aufgrund des reflektierenden Elementes R eine Verwendung eines Magneten (inklusive der dadurch bedingten Nachteile) entbehrlich ist. Insbesondere kann keine Entmagnetisierung oder eine Manipulation durch externe Magnetfelder erfolgen, die die Funktionsweise der erfindungsgemäßen Anordnung einschränken würde. Vielmehr reicht in der vorliegenden Ausgestaltung der Erfindung die Verwendung des reflektierenden Elementes R im Zusammenspiel mit dem Sender Y und dem Sensor H aus.

Figur 2 zeigt links ein herkömmliches Funktionsmodul F zum Einbau in eine Installationsdose D für ein elektrisches/elektronisches Schaltgerät S der Gebäudeinstallationstechnik, wobei das Funktionsmodul F mittels eines Betätigungselementes B eines Oberteils O des elektrischen/elektronischen Schaltgerätes S durch mechanische Betätigung, insbesondere durch Betätigung einer Schaltwippe, beeinflussbar ist. Dieses Funktionsmodul F umfasst ein Gehäuse G, in dessen Innenraum auf zumindest einer elektrischen Leiterplatte zur Funktion notwendige elektrische/elektronische Bauteile untergebracht sind. Dabei weist die zumindest eine elektrische Leiterplatte zum Anschluss mehrerer elektrischer Leitungen zumindest eine Schnittstelle auf. Die Anzahl der Steuerleitungen 1,2 ist vorliegend bei der erfindungsgemäßen Anordnung bezüglich des Standes der Technik halbiert, da lediglich die Ansteuerung der zu steuernden Last nötig ist; auch die sogenannte fliegende Verkabelung bezüglich der Phase L entfällt. Das vorliegende, einen Schaltaktor SA umfassende Funktionsmodul F kann in dieser Ausführungsform über diese Schnittstelle eine Steckdose schalten. Dafür ist bei der erfindungsgemäßen Anordnung, umfassend das Funktionsmodul F (rechts abgebildet) an dem Oberteil O des elektrischen/elektronischen Schaltgerätes S mindestens ein reflektierendes Element R angeordnet, welches bei Betätigung des Betätigungselementes B seine Position ändert. Diese Änderung der Position, insbesondere durch ein Schwenken entlang der Drehachse einer Schaltwippe, wird in dem Funktionsmodul F über einen Sensor H zur Erfassung des optischen Signals V beziehungsweise dessen Intensität zeitaufgelöst erfasst. Die sensierte Änderung des optischen Signals V beziehungsweise dessen Intensität wird anschließend in einer Auswerteeinheit zur Identifikation des elektrischen/elektronischen Schaltgerätes S als Schalter ausgewertet. Bei einem Schalter kann es sich auch um einen Drehschalter handeln. Damit kann sichergestellt werden, dass die Ansteuerung eines elektrischen Gerätes, beispielsweise einer Steckdose, durch das Funktionsmodul F so erfolgt, dass das elektrische/elektronische Schaltgerät S als Schalter erkannt und angesteuert wird. Eine Ansteuerung als Schalter unterscheidet sich fundamental von der eines Tasters, insbesondere dahingehend, dass der Schalter nicht in seine Ursprungsposition zurückspringt und somit der Schalter eine permanente Offen- beziehungsweise Geschlossenen-Stellung einnimmt. Dieses erlaubt eine Auswertung beziehungsweise Identifikation durch die Auswerteeinheit als Schalter beziehungsweise als Taster. Eine solche Identifikation durch die Auswerteeinheit kann beispielsweise erfolgen, indem das optische Signal V beziehungsweise dessen Intensität zeitaufgelöst erfasst wird, wobei sich auf vorteilhafte Weise zu Nutze gemacht wird, dass bei einer Schalterbetätigung, um dieselbe Änderung des optischen Signals V wie bei einer Tastbetätigung herbeizuführen, der Bediener bei der Bedienung umgreifen muss (Doppelbetätigung), so dass die Schalterbetätigung regelmäßig länger dauert als eine Tastbetätigung (Einfachbetätigung reicht aus). Dieses erlaubt eine einfache und zuverlässige Identifikation des elektrischen/elektronischen Schaltgerätes S als Taster oder Schalter. Eine solche Identifikation kann alternativ auch erreicht werden, indem eine manuelle Vor-Orteinstellung am Funktionsmodul F (beispielsweise über eine Einstellmöglichkeit am Funktionsmodul F) oder über eine Fernbetätigung (beispielsweise über eine Applikation auf einem mobilen Endgerät oder über anderweitig über eine Funkkommunikation) vorgenommen wird. Damit wird durch das erfindungsgemäße Funktionsmodul F erreicht, dass das elektrische/elektronische Schaltgerät S zwar noch als mechanischer Schalter zur Aufnahme einer Wippe dient, dieses elektrische/elektronische Schaltgerät S jedoch keine elektronische Verbindung, also: Verdrahtung, zu dem Funktionsmodul F mehr aufweist. Hierdurch wird der insgesamt zu leistende Verdrahtungsaufwand erheblich reduziert. Ebenfalls wird hierdurch verhindert, dass sich beim Einsetzen des Funktionsmoduls F in die Installationsdose möglicherweise angeschlossenes Kabelgut löst.

In allen Ausführungsformen kann der Verdrahtungsaufwand mit Blick auf den Anschluss des erfindungsgemäßen Funktionsmoduls F an die Phase L und den Neutralleiter N noch weiter abgesenkt werden, wenn das Funktionsmodul F über einen Energiespeicher, insbesondere eine Batterie, energieversorgt ist.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste. Die Erfindung ist jedoch durch den Rahmen der folgenden Ansprüche definiert.

### Bezugszeichenliste

- B: Betätigungselement
- D: Installationsdose
- EM: Einstellmittel
- F: Funktionsmodul
- G: Gehäuse
- K: Spreizkralle
- L: Phase
- H: Sensor
- N: Neutralleiter
- O: Oberteil
- R: reflektierendes Element
- SA: Schaltaktor
- S: elektrisches/elektronisches Schaltgerät
- T: Einbautiefe
- TA: Tasterschnittstelle
- V: optisches Signal
- X: Ausnehmung
- Y: Sender
- 1-2: Steuerleitungen

## Patentansprüche

1. Anordnung eines Funktionsmoduls (F) zum Einbau in eine Installationsdose (D), einer Installationsdose (D) und eines manuell zu betätigenden elektrischen/elektronischen Schaltgeräts (S) der Gebäudeinstallationstechnik, welches Funktionsmodul (F) durch die Betätigung eines an dem elektrischen/elektronischen Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements (B) ansteuerbar ist, **dadurch gekennzeichnet, dass** das Funktionsmodul (F) einen Sender (Y) und einen Sensor (H) zur Erfassung eines durch den Sender (Y) erzeugten optischen Signals (V) aufweist,
wobei an dem elektrischen/elektronischen Schaltgerät (S) mindestens ein reflektierendes Element (R) angeordnet ist, welches bei Betätigung des Betätigungselementes (B) seine Position ändert, so dass die Änderung des optischen Signals (V) bei Betätigung des Betätigungselementes (B) durch den Sensor (H) detektiert wird,
wobei der Sender (Y) direkt auf eine Rückseite der Installationsdose (D) gerichtet ist, und das optische Signal (V) von der Rückseite aus in sämtliche Richtungen reflektiert wird, wobei ein Teil des reflektierten optischen Signals (V) auf das reflektierende Element (R) gelangt, so dass die Positionsänderung des reflektierenden Elements (R) sich in eine Intensitätsänderung am Sensor (H) übersetzt, und
wobei das Funktionsmodul (F) eine Auswerteeinheit zur Auswertung der Änderung des optischen Signals (V) aufweist, die dazu eingerichtet ist, in Abhängigkeit der sensierten Änderung des optischen Signals (V) zu identifizieren, um welche Schaltgeräteart es sich bei dem elektrischen/elektronischen Schaltgerät (S) handelt, welche Identifikation in die funktionsmodulseitige Ansteuerung des Aktors einfließt.

2. Anordnung nach Anspruch 1, **dadurch gekennzeichnet, dass** das reflektierende Element (R) an der von dem Benutzer im Betrieb abgewandten Seite des Betätigungselementes (B) angeordnet, insbesondere geklebt oder mechanisch an ihm fixiert, ist.

3. Anordnung nach einem der Ansprüche 1 bis 2, **dadurch gekennzeichnet, dass** das elektrische/elektronische Schaltgerät (S) als Taster oder als Schalter ausgebildet ist.

4. Anordnung nach einem der Ansprüche 1 bis 3, **dadurch gekennzeichnet, dass** das Funktionsmodul (F) einen Dimmaktor zum Dimmen einer dimmbaren Last umfasst.

5. Anordnung nach einem der Ansprüche 1 bis 4, **dadurch gekennzeichnet, dass** das Funktionsmodul (F) einen Schaltaktor (SA), insbesondere zum Schalten von Steckdosen, üblicherweise haushalts-üblicher Steckdosen, umfasst.

6. Anordnung nach einem der Ansprüche 1 bis 5, **dadurch gekennzeichnet, dass** das Funktionsmodul (F) einen Jalousieaktor zum Steuern von Jalousien umfasst.

7. Anordnung nach einem der Ansprüche 1 bis 6, **dadurch gekennzeichnet, dass** das Funktionsmodul (F) einen Tastsensor zum Betätigen eines elektrischen Gerätes umfasst.

8. Anordnung nach einem der Ansprüche 1 bis 7, **dadurch gekennzeichnet, dass** der Sensor (H) eine Photodiode ist.

9. Anordnung nach einem der Ansprüche 1 bis 8, **dadurch gekennzeichnet, dass** der Sender (Y) außerhalb des spektralen Bereiches von 380 nm bis 780 nm emittiert.

10. Anordnung nach einem der Ansprüche 1 bis 9, **dadurch gekennzeichnet, dass** das der Sensor (Y) einen Tageslicht-Sperrfilter aufweist.

11. Anordnung nach einem der Ansprüche 1 bis 10, **dadurch gekennzeichnet, dass** das Funktionsmodul (F) über einen Energiespeicher, insbesondere eine Batterie, energieversorgt ist.

12. Verfahren zum Betrieb einer Anordnung nach einem der Ansprüche 1-11, umfassend die Schritte:
- Erzeugen des optischen Signals (V) durch den Sender (Y),
- Erfassen des optischen Signals (V) durch den Sensor (H),
- Erfassen der Änderung des optischen Signals (V) in Folge einer vorbestimmten Betätigung des Betätigungselementes (B) in Folge der Bewegung des reflektierenden Elements (R),
- Auswerten der erfassten Änderung des optischen Signals durch eine Auswerteeinheit, dahingehend, um welche Schaltgeräteart es sich bei dem elektrischen/elektronischen Schaltgerät (S) handelt, insbesondere, ob es sich um einen Schalter oder Taster handelt, und
- Ansteuerung eines Aktors durch das Funktionsmodul (F) entsprechend einer vorgegebenen Funktionsweise in Abhängigkeit der Schaltgeräteart.

## Claims

1. Arrangement of a function module (F) for installation in a wall box (D), a wall box (D) and a manually operable electrical/electronic switching device (S) for building installation systems, which function module (F) can be influenced by operation of an operating element (B) of a top part (O) of the switching device (S), which operating element is connected to the electrical/electronic switching device (S), the function module (F) having at least one interface by means of which at least one actuator can be controlled corresponding to an operation of the operating element (B), **characterised in that** the function module (F) has a transmitter (Y) and a sensor (H) for detecting an optical signal (V) generated by the transmitter (Y), wherein at least one reflective element (R) is arranged on the electrical/electronic switching device (S), which changes its position when the actuating element (B) is actuated, so that the change in the optical signal (V) is detected by the sensor (H) when the actuating element (B) is actuated,
wherein the transmitter (Y) is directed directly onto a rear side of the wall box (D) and the optical signal (V) is reflected from the rear side in all directions, wherein a part of the reflected optical signal (V) reaches the reflecting element (R) so that a change in position of the reflecting element (R) is translated into an intensity change at the sensor (H), and wherein the function module (F) has an evaluation unit for evaluating the change in the optical signal (V), which is set up to identify, as a function of the sensed change in the optical signal (V), which type of switching device the electrical/electronic switching device (S) is, which identification is incorporated into the activation of the actuator on the side of the function module.

2. Arrangement according to claim 1, **characterised in that** the reflecting element (R) is arranged on the side of the operating element (B) facing away from the user during operation, in particular glued or mechanically fixed to it.

3. Arrangement according to any of claims 1 to 2, **characterised in that** the electrical/electronic switching device (S) is designed as push-button or as switch.

4. Arrangement according to any of claims 1 to 3, **characterised in that** the function module (F) comprises a dimming actuator for dimming of a dimmable load.

5. Arrangement according to any of claims 1 to 4, **characterised in that** the function module (F) comprises a switching actuator (SA), in particular for switching socket outlets, usually household socket outlets.

6. Arrangement according to any of claims 1 to 5, **characterised in that** the function module (F) comprises a shutter actuator to control shutters.

7. Arrangement according to any of claims 1 to 6, **characterised in that** the function module (F) comprises a push-button sensor for operation of an electrical device.

8. Arrangement according to any of claims 1 to 7, **characterised in that** the sensor (H) is a photoelectric diode.

9. Arrangement according to any of claims 1 to 8, **characterized in that** the transmitter (Y) emits outside the spectral range from 380 nm to 780 nm.

10. Arrangement according to any of claims 1 to 9, **characterized in that** the sensor (Y) has a daylight cut filter.

11. Arrangement according to any of claims 1 to 10, **characterized in that** the function module (F) is supplied with energy by means of an energy store, in particular a battery.

12. Method for operating an arrangement according to one of claims 1-11, comprising the steps of:
- generating the optical signal (V) by the transmitter (Y),
- detecting the optical signal (V) by the sensor (H),
- detecting the change in the optical signal (V) as a result of a predetermined actuation of the actuating element (B) as a result of the movement of the reflecting element (R),
- evaluating the detected change in the optical signal by means of an evaluation unit, in order to determine which type of switching device the electrical/electronic switching device (S) is, in particular whether it is a switch or a push-button, and
- activating an actuator by means of the function module (F) in accordance with a predetermined function depending on the type of switching device.

## Revendications

1. Arrangement d'un module fonctionnel (F) destiné à être monté dans une boîte d'installation (D), d'une boîte d'installation (D) et d'un commutateur électrique/électronique (S) de la technique d'installation du bâtiment à actionner manuellement, lequel module fonctionnel (F) peut être influencé par l'actionnement d'un élément d'actionnement (B) d'une partie supérieure (O) du commutateur (S) raccordé au commutateur électrique/électronique (S), le module fonctionnel (F) présentant au moins une interface au moyen de laquelle au moins un actionneur peut être commandé en fonction d'un actionnement de l'élément d'actionnement (B), **caractérisé en ce que** le module fonctionnel (F) présente un émetteur (Y) et un capteur (H) pour détecter un signal optique (V) généré par l'émetteur (Y), au moins un élément réfléchissant (R) étant disposé sur le commutateur électrique/électronique (S), lequel élément change de position lorsque l'élément d'actionnement (B) est actionné, de sorte que le changement du signal optique (V) est détecté par le capteur (H) lorsque l'élément d'actionnement (B) est actionné,
l'émetteur (Y) étant dirigé directement vers l'arrière de la boîte d'installation (D) et le signal optique (V) étant réfléchi dans toutes les directions depuis l'arrière, une partie du signal optique réfléchi (V) atteignant l'élément réfléchissant (R), de sorte que le changement de position de l'élément réfléchissant (R) se traduit par un changement d'intensité au niveau du capteur (H), et le module fonctionnel (F) comportant une unité d'évaluation pour évaluer la modification du signal optique (V), qui est conçue pour identifier, en fonction de la modification détectée du signal optique (V), de quel type de commutateur il s'agit pour le commutateur électrique/électronique (S), cette identification étant intégrée dans la commande de l'actionneur côté module fonctionnel.

2. Arrangement selon la revendication 1, **caractérisé en ce que** l'élément réfléchissant (R) est disposé sur le côté de l'élément d'actionnement (B) opposé à l'utilisateur pendant le fonctionnement, en particulier collé ou fixé mécaniquement à celui-ci.

3. Arrangement selon l'une des revendications 1 à 2, **caractérisé en ce que** le commutateur électrique/électronique (S) est conçu comme un bouton-poussoir ou comme un interrupteur.

4. Arrangement selon l'une des revendications 1 à 3, **caractérisé en ce que** le module fonctionnel (F) comprend un actionneur de variation pour faire varier une charge variable.

5. Arrangement selon l'une des revendications 1 à 4, **caractérisé en ce que** le module fonctionnel (F) comprend un actionneur de commutation (SA), en particulier pour la commutation de prises de courant, généralement des prises de courant domestiques.

6. Arrangement selon l'une des revendications 1 à 5, **caractérisé en ce que** le module fonctionnel (F) comprend un actionneur de store pour commander des stores.

7. Arrangement selon l'une des revendications 1 à 6, **caractérisé en ce que** le module fonctionnel (F) comprend un capteur tactile pour actionner un appareil électrique.

8. Arrangement selon l'une des revendications 1 à 7, **caractérisé en ce que** le capteur (H) est une photodiode.

9. Arrangement selon l'une des revendications 1 à 8, **caractérisé en ce que** l'émetteur (Y) émet en dehors de la plage spectrale de 380 nm à 780 nm.

10. Arrangement selon l'une des revendications 1 à 9, **caractérisé en ce que** le capteur (Y) comporte un filtre de blocage de la lumière du jour.

11. Arrangement selon l'une des revendications 1 à 10, **caractérisé en ce que** le module fonctionnel (F) est alimenté en énergie par un accumulateur d'énergie, en particulier une batterie.

12. Procédé pour faire fonctionner un arrangement selon l'une des revendications 1 à 11, comprenant les étapes suivantes:
- Génération du signal optique (V) par l'émetteur (Y),
- Détection du signal optique (V) par le capteur (H),
- Détection de la modification du signal optique (V) suite à un actionnement prédéterminé de l'élément d'actionnement (B) suite au mouvement de l'élément réfléchissant (R),
- Evaluation de la modification du signal optique détectée par une unité d'évaluation, afin de déterminer de quel type de commutateur il s'agit pour le commutateur électrique/électronique (S), en particulier s'il s'agit d'un interrupteur ou d'un bouton-poussoir, et
- Commande d'un actionneur par le module fonctionnel (F) selon un mode de fonctionnement prédéfini en fonction du type de commutateur.
